(19) Europäisches Patentamt
European Patent Office
Office européen des brevets

(11) EP 2 911 875 B1

(12) EUROPÄISCHE PATENTSCHRIFT

(45) Veröffentlichungstag und Bekanntmachung des Hinweises auf die Patenterteilung:
**12.05.2021 Patentblatt 2021/19**

(21) Anmeldenummer: **13782719.2**

(22) Anmeldetag: **24.10.2013**

(51) Int Cl.:
**B32B 17/06** *(2006.01)* **B32B 17/10** *(2006.01)*
**B32B 1/02** *(2006.01)* **B32B 1/08** *(2006.01)*

(86) Internationale Anmeldenummer:
**PCT/EP2013/072297**

(87) Internationale Veröffentlichungsnummer:
**WO 2014/064204 (01.05.2014 Gazette 2014/18)**

(54) **VERBUNDMATERIAL FÜR EIN PHARMAZEUTISCHES PACKMITTEL, VERFAHREN ZU DESSEN HERSTELLUNG UND VERWENDUNG DES VERBUNDMATERIALS**

COMPOSITE MATERIAL FOR A PHARMACEUTICAL PACKAGING MEANS, METHOD FOR THE PRODUCTION THEREOF, AND USE OF THE COMPOSITE MATERIAL

MATÉRIAU COMPOSITE DESTINÉ À UN EMBALLAGE PHARMACEUTIQUE, ET PROCÉDÉ DE FABRICATION ET UTILISATION DUDIT MATÉRIAU COMPOSITE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.10.2012 DE 102012110131**

(43) Veröffentlichungstag der Anmeldung:
**02.09.2015 Patentblatt 2015/36**

(73) Patentinhaber: **Schott AG**
**55122 Mainz (DE)**

(72) Erfinder:
• **BICKER, Matthias**
**55126 Mainz (DE)**
• **LOHMEYER, Manfred**
**55299 Nackenheim (DE)**
• **WOYWOD, Tanja**
**55126 Mainz (DE)**

(74) Vertreter: **Blumbach · Zinngrebe Patentanwälte PartG mbB**
**Alexandrastraße 5**
**65187 Wiesbaden (DE)**

(56) Entgegenhaltungen:
EP-A1- 0 709 105 EP-A1- 0 858 975
EP-A2- 0 920 879 US-A- 4 686 124
US-A1- 2013 171 456

**Beschreibung**

Gebiet der Erfindung

Die Erfindung betrifft ein Verbundmaterial für ein pharmazeutisches Packmittel aus einem Glas-, COC-, oder COP-Substrat, auf welches eine Schutzschicht aufgebracht ist, sowie ein Verfahren zu dessen Herstellung. Ferner betrifft die Erfindung einen Behälter aus dem Verbundmaterial und eine Verwendung des Verbundmaterials zur Verhinderung einer Delamination des Substrats, sowie als Barriere.

Hintergrund der Erfindung

Bei einer Lagerung von flüssigen Produkten oder flüssigen Wirkstoffformulierung in pharmazeutischen Packmittel, beispielsweise in Fläschchen, Ampullen, Karpulen oder Spritzen, muss das Material, welches in Kontakt mit dem Produkt tritt, hohe Anforderungen bezüglich der chemischen Beständigkeit erfüllen. Hierbei kommt es vor allem darauf an, dass aus dem Wandmaterial des Packmittels keine Stoffe entweichen, welche das darin gelagerte Produkt kontaminieren könnten.
Bei Packmitteln aus Glas kann es jedoch, sofern darin Produkte wie beispielsweise Phosphat- oder Citratpuffer, oder Salz-haltige Lösungen gelagert oder verwendet werden, während der Lagerung zu einer Glas-Delamination kommen.
Hierbei kann eine Auslösung von Glasflittern stattfinden Die EP 0 858 975 A1 offenbart sterilisierbare Glasbehälter für medizinische Zwecke, die mit direktem Kontakt mit dem Inhalt kommen. Dieser Inhalt soll geschützt werden. Die Gläser oder Glasbehälter werden oberflächenbehandelt mittels eines Plama-CVD-Verfahrens, wobei eine Schicht aus Oxiden und / oder Nitriden der Elemente Si, Ti, Ta oder A1 überzogen wird.

Allgemeine Beschreibung der Erfindung

Der Erfindung liegt die Aufgabe zugrunde, ein Material für pharmazeutische Packmittel mit verbesserter chemischer und physikalischer Beständigkeit gegenüber medizinischen oder pharmazeutischen Produkten bereitzustellen.
Diese Aufgabe wird in höchst überraschend einfacher Weise durch den Gegenstand der unabhängigen Ansprüche gelöst. Vorteilhafte Ausgestaltungen und Weiterbildungen sind in den abhängigen Ansprüchen angegeben. Die Merkmale der Weiterbildungen können, soweit technisch sinnvoll, miteinander kombiniert werden.
Ein Aspekt der Erfindung betrifft ein Verbundmaterial für ein pharmazeutisches Packmittel. Unter einem pharmazeutischen Packmittel kann ein Behälter, oder ein Fläschchen, oder eine Spritze, oder eine Karpule, oder eine Ampulle, oder ein Rohr verstanden werden.
Das Verbundmaterial kann ein Substrat und eine Schutzschicht umfassen. Die Schutzschicht kann als Sperrschicht oder Barriereschicht zum Schutz des Substrats und zum Verhindern einer Delamination des Substrats aufgefasst werden.
Das Substrat kann einen Kontaktbereich mit der Schutzschicht aufweisen. Der Kontaktbereich kann die Kontaktfläche zwischen Substrat und Schutzschicht, sowie einen oberflächennahen Bereich des Substrats umfassen. Der Kontaktbereich hat damit eine laterale Ausdehnung entlang der Kontaktfläche zwischen Substrat und Schutzschicht und eine vertikale Ausdehnung in die Tiefe des Substrats, senkrecht zur Kontaktfläche zwischen Substrat und Schutzschicht.
Die vertikale Ausdehnung, beziehungsweise die Dicke des Kontaktbereichs kann mindestens 0,0001%, mindestens 0,01%, mindestens 0,1%, mindestens 1%, mindestens 10% oder mindestens 50% der Substratdicke betragen. Die vertikale Ausdehnung kann auch mindestens der Substratdicke entsprechen.
Die laterale Ausdehnung des Kontaktbereichs kann einer Fläche von mindestens $2*10^{-13}$%, mindestens $2*10^{-11}$%, mindestens $2*10^{-6}$%., mindestens $2*10^{-4}$%, mindestens 0,01%, mindestens 0,1%, mindestens 1%, mindestens 10%, mindestens 40% oder mindestens 50% der Substratoberfläche entsprechen.
Das Substrat kann aus Glas ausgebildet sein. Das gesamte Substrat kann aus Glas bestehen, oder es kann nur derjenige Bereich des Substrats aus Glas bestehen, welcher der Kontaktfläche zwischen Substrat und Schutzschicht entspricht.
Die Beschaffenheit des Substrats im Kontaktbereich kann gegenüber der Beschaffenheit des Substrats außerhalb des Kontaktbereichs verschieden sein. Die Beschaffenheit betrifft die chemischen und/oder physikalischen Eigenschaften des Substrats.
Das Substrat kann als ein Flachsubstrat, beispielsweise eine Glasscheibe, oder als ein gewölbtes Substrat, beispielsweise ein Innenbereich eines Behälters, ausgebildet sein.
Die Schutzschicht kann aus einem keramischen Material bestehen, das heißt als eine keramische kristalline Beschichtung ausgebildet sein.

Die Schutzschicht kann auch als eine amorphe Beschichtung aus dem keramischen Material ausgebildet sein, wie beispielsweise eine amorphe Schicht aus

- Siliziumcarbid,
- oxidiertem Siliziumcarbid,
- nitridiertem Siliziumcarbid, oder
- oxidiertem, nitridiertem Siliziumcarbid, oder
- Siliziumnitrid,
- Siliziumoxinitrid,
- Aluminiumoxid,
- Aluminiumnitrid, oder
- Aluminiumoxynitrid, oder
- Zirkonoxid, oder
- Siliziumoxid, d.h. einer amorphen Schicht aus Quarz als keramisches Material.

Ferner können die Schichten auch Wasserstoff-haltig sein und beispielsweise aus hydrogenisiertem Siliziumcarbid, hydrogenisiertem Siliziumoxid oder aus einer hydrogenisierten Form einer der anderen vorstehend beschriebenen Verbindungen bestehen.

Bei der Lagerung eines flüssigen Produkts in einem Behälter aus Glas kann es während der Lagerung zu einer Glas-Delamination, d.h. zu einer partiellen Auslösung von Glasflittern, kommen.

Durch die Schutzschicht kann das Substrat versiegelt werden. Damit kann vorteilhafter Weise eine Anti-Delaminations-Wirkung und eine verbesserte Schichtbeständigkeit erzielt werden, sofern der Behälter, zur Lagerung eines flüssigen Produkts, aus dem Verbundmaterial ausgebildet ist.

Die Schutzschicht und deren kovalente Anbindung an die Oberfläche des Kontaktbereichs, beziehungsweise der inhomogenen Zone kann vorteilhafter Weise eine Diffusion von Ionen aus dem flüssigen Produkt hemmen. Dadurch kann eine Auslösung von Substratbestandteilen durch eine chemische Wechselwirkung zwischen dem Produkt und dem Substrat verhindert werden.

Das Verbundmaterial weist auf diese Weise einen gegenüber einem konventionellen Glassubstrat verbesserten Korrosionsschutz auf.

Ein weiterer Aspekt der Erfindung betrifft ein Verfahren zum Herstellen eines Verbundmaterials mit einem Substrat und einer Schutzschicht.

Das Substrat kann aus Glas ausgebildet sein. Die Beschaffenheit des Substrats in einem oberflächennahen Bereich des Substrats kann von der Beschaffenheit des Substrats außerhalb des oberflächennahen Bereichs verschieden sein.

Die Schutzschicht kann mittels eines Plasmas auf das Substrat abgeschieden werden, vorzugsweise unter Zersetzung eines Disilan-Precursors. Der Stoff der Schutzschicht kann Keramik sein.

Ein weiterer Aspekt der Erfindung betrifft ein kombiniertes Verfahren zum Herstellen des erfindungsgemäßen Verbundmaterials.

In einem Schritt des Verfahrens kann Sauerstoff aus dem Substrat in eine Gasphase mittels Plasma-Ätzung überführt werden.

In einem weiteren Schritt des Verfahrens kann der Sauerstoff in die Schutzschicht mittels Plasma-Abscheidung deponiert werden.

In einem weiteren Schritt kann die Schutzschicht nach der Plasma-Abscheidung durch Einwirkung eines Sauerstoff- und/oder Stickstoff-haltigen Gasgemisches nachbehandelt werden.

Durch das kombinierte Verfahren kann auf sehr einfache Weise Stickstoff in der Schichtoberfläche eingebaut werden, wodurch eine Vereinfachung des Herstellprozesses erreicht wird.

Ein Aspekt der Erfindung betrifft einen Behälter für ein medizinisches oder pharmazeutisches Produkt. Das Produkt kann beispielsweise alkalische Wirkstoffe, proteinbasierte Wirkstoffe oder oberflächenaktive Tenside, sogenannte 'Surfactants', umfassen.

Zumindest in einem Innenbereich kann der Behälter aus dem erfindungsgemäßen Verbundmaterial ausgebildet sein.

Ein weiterer Aspekt der Erfindung betrifft eine Verwendung des erfindungsgemäßen Verbundmaterials in einem Hohlkörper, der in einem Innenbereich Kontakt mit einem flüssigen Produkt hat, zur Verhinderung einer Delamination des Hohlkörpers oder eines chemischen Angriffs auf den Hohlkörper durch das Produkt.

Der Hohlkörper kann als ein Rohr, oder ein Behälter, wie beispielsweise ein pharmazeutischen Packmittel oder ein Fläschchen, für das flüssige Produkt ausgebildet sein.

Der Hohlkörper kann auch als eine Spritze, oder eine Karpule, oder eine Ampulle für das flüssige Produkt ausgebildet sein. Das Produkt kann durch den Hohlkörper zirkulieren, falls dieser als ein Rohr ausgebildet ist. Das Produkt kann in dem Hohlkörper aufbewahrt oder gelagert werden, falls der Hohlkörper als Behälter für das Produkt ausgebildet ist.

Die nachfolgenden Weiterbildungen und Ausführungsformen der Erfindung können mit den obigen Aspekten der Erfindung kombiniert werden.

Bei einer Weiterbildung der Erfindung kann das Substrat aus Glas der hydrolytischen Klasse I-V ausgebildet sein.

Insbesondere kann das Substrat aus Borosilikat-Glas der hydrolytischen Klasse I ausgebildet sein, das vorteilhafter Weise gegenüber anderen Gläsern eine bessere

Korrosionsbeständigkeit aufweist. Dieser Vorzug kann mittels Beschichtung mit der Schutzschicht weiter verstärkt werden.

Die Beschaffenheit des Substrats im Kontaktbereich betrifft die Oberflächenrauigkeit. Die Oberflächenrauigkeit des Substrats im Kontaktbereich kann von der Oberflächenrauigkeit des Substrats außerhalb des Kontaktbereichs verschieden sein.

Die Beschaffenheit des Substrats im Kontaktbereich betrifft die chemische Zusammensetzung. Die chemische Zusammensetzung des Substrats im Kontaktbereich kann von der chemischen Zusammensetzung des Substrats außerhalb des Kontaktbereichs verschieden sein.

Gemäß einer vorteilhaften Ausführungsform kann der Kontaktbereich chemische Elemente von Glas enthalten, wobei wenigstens eines der Elemente des Kontaktbereichs von der Zusammensetzung vom Substrat abweicht. Der Kontaktbereich kann vorzugsweise

- die Elemente Si und O, oder
- wenigstens eines der Elemente Na, B, oder
- wenigstens eines der folgenden Elemente: Al, K, Ca, Mg, Ba, Cl

enthalten.

Die Beschaffenheit des Substrats im Kontaktbereich betrifft die Oberflächenenergie. Die Oberflächenenergie des Substrats im Kontaktbereich kann von der Oberflächenenergie des Substrats außerhalb des Kontaktbereichs verschieden sein.

Die Beschaffenheit des Substrats im Kontaktbereich betrifft die chemische Ätzrate. Die chemische Ätzrate des Substrats im Kontaktbereich kann von der chemischen Ätzrate des Substrats außerhalb des Kontaktbereichs verschieden sein.

Gemäß einer Ausführungsform kann die Schutzschicht über van-der Waals-Kräfte und/oder kovalent an die Oberfläche des Substrats angebunden sein.

Die Schutzschicht kann amorph, oder gegebenenfalls teil-kristallin, kristallin oder nano-kristallin sein. Die Schutzschicht kann vorzugsweise aus der Gasphase abgeschieden sein.

Vorzugsweise kann die Schutzschicht eine geringe Dichte an strukturellen Defekten aufweisen, wie inneren Grenzflächen, Poren oder Mikrorissen, oder wenige räumlich ausgedehnte strukturelle Defekte, wie innere Grenzflächen, die senkrecht zur Substratoberfläche ausgerichtet sind und somit einen kurzen Diffusionsweg für einen korrosiven Angriff ermöglichen.

Die Schutzschicht kann eine wellenlängenabhängige Absorption aufweisen, wobei der Extinktionskoeffizient ab einer Wellenlänge von 500nm bis zu einer Wellenlänge von 250nm mit abnehmender Wellenlänge ansteigt, wobei der Anstieg vorzugweise steiler oder stärker als linear ist.

Dieses Absorptionsverhalten kann eine Substrat-Transmission von kurzwelligem Licht reduzieren oder verhindern. Nachdem kurzwelliges Licht auf ein Medikament eine schädigende Wirkung hat, ist das genannte Absorptionsverhalten sehr vorteilhaft bei Verwendung des Verbundmaterials in einem pharmazeutischen Packmittel, Behälter, einer Spritze oder Ähnlichem. Das genannte Absorptionsverhalten ist darüber hinaus auch hinsichtlich Fälschungssicherheit ('Anti-Counterfeiting') vorteilhaft.

Der Brechungsindex n der Schutzschicht fällt in einem Wellenlängenbereich zwischen 250nm und 1000nm stetig ab von einem Anfangswert $n_{250nm} \approx < 2{,}8$ bei 250nm, vorzugsweise $n_{250nm} \approx < 2{,}5$ auf einem Endwert $n_{2000nm} > \approx 1{,}5$ bei 1000nm, vorzugsweise $n_{2000nm} > \approx 1{,}6$, besonders bevorzugt $n_{2000nm} > \approx 1{,}65$. Hierbei bedeuten "n $\approx < $ x", dass n in der Größenordnung von x, jedoch kleiner als x ist und "n $> \approx$ x", dass n in der Größenordnung von x, jedoch größer als x ist.

Der Vorteil einer amorphen Schutzschicht gegenüber einer mikrokristallinen Schicht kann darin liegen, dass die amorphe Schutzschicht keine Korngrenzen aufweist. Solche Korngrenzen können Diffusionspfade bei einem durch Diffusion bedingten korrosiven Angriff sein. Die GasphasenAbscheidung ermöglicht vorteilhafter Weise eine Bildung von Schichten mit geringer Defektdichte und damit verbundener hoher Barriere-Wirkung.

Die Schutzschicht kann zumindest in einem Teilbereich frei von Siliciumdioxid SiO2 sein. Dies kann von besonderem Vorteil sein, da bei einer Schicht aus Siliziumdioxid das Siliziumoxid-Netzwerk insbesondere von alkalischen Lösungen angegriffen und aufgelöst wird. Daher ist ein geringerer Anteil an SiO2 zu bevorzugen. Insbesondere an der Schichtoberfläche ist eine Schicht zu bevorzugen, die von der reinen SiO2-Zusammensetzung abweicht.

Die Schutzschicht kann eines oder mehrere der folgenden Stoffe oder Bindungen enthalten:

- Siliziumcarbid SiC,
- hydrogenisiertes oxydiertes Siliziumcarbid SiC:OH,
- nitriertes oxidiertes hydrogenisiertes Siliziumcarbid SiC:OHN,
- Stickstoff N,
- N-H-Bindungen oder C-N-Bindungen, wobei diese Bindungen vorzugsweise durch Stoffe erzeugt werden können, welche diese Bindungen, oder N2 und einen Wasserstoff-haltigen organischen Precursor enthalten.

Ein Vorteil des Stickstoff-Anteils in der Schutzschicht ist, dass das Substrat gegenüber einem chemischen Angriff stabiler wird. Zudem können Oberflächeneigenschaften, wie die Festigkeit der Schicht, dadurch weiter verbessert werden.

Die genannte Zusammensetzung der Schutzschicht kann eine Anti-Delaminations-Wirkung haben, wodurch eine Bildung von glasflitterartigen Partikeln während eines Kontakts des Verbundmaterials mit einem flüssigen Produkt, beispielsweise bei der Einlagerung des Produkts in einem Behälter, der aus dem Verbundmaterial ausgebildet ist.

Die genannte Zusammensetzung der Schutzschicht kann ferner eine Beständigkeit gegen alkalische Produkte, beispielsweise Reiniger, bewirken. Sowohl ein Angriff der Substratoberfläche als auch ein hydrolytischer Angriff der Schutzschicht kann damit verhindert werden.

Die Zusammensetzung der Schutzschicht kann insbesondere die Beständigkeit gegen

- saure und alkalische Lösungen,
- alkalische Lösungen im Bereich pH7 bis pH12,
- Phosphat- oder Citratpuffer,
- Ammoniumchlorid-Ammoniak-Pufferlösungen,
- Azetat-Pufferlösungen,
- Lösungen, die Aminoessigsäure (Glycin) oder Glutarsäure enthalten,
- Salz-haltige Lösungen, die beispielsweise Natriumchlorid oder Kaliumchlorid enthalten,
- Eisen-haltige Formulierungslösungen,
- Bestandteile von Reinigungslösungen, oder
- ein Phosphat-Citrat-Puffer-System

erheblich verbessern.

Die Schutzschicht kann das darunterliegende Substrat erheblich aufwerten. So kann eine Schutzschicht aus Siliziumcarbid, die auf einem Substrat aus Glas der hydrolytischen Klasse II aufgebracht ist, für das Verbundmaterial ein Niveau von Glas der hydrolytischen Klasse I bezüglich einer Alkali-Auslaugung bewirken.

Eine Siliziumcarbid-basierte Schutzschicht weist eine exzellente Temperaturbeständigkeit, beispielsweise von oberhalb von 250°C, 350°C oder 500°C für eine Dauer mehr als 30 Minuten auf. Dies ermöglicht einen Einsatz in der Sterilisation im Hitzetunnel oder eine thermische Nachbehandlung des beschichteten Substrats.

Die Schutzschicht kann eine stabile Schichtfunktion oder Barriere-Funktion für Hochtemperatur-Anwendungen ermöglichen.

Gemäß einer Ausführungsform kann die Schutzschicht zwei Schichten aufweisen. Hierbei kann eine erste Schicht als Basisschicht ausgebildet sein und eine zweite Schicht kann als oberflächennahe Schicht ausgebildet sein.

Die zweite Schicht kann eine gegenüber der ersten Schicht unterschiedliche Zusammensetzung haben.

Die unterschiedliche Zusammensetzung kann darin bestehen, dass die zweite Schicht einen gegenüber der ersten Schicht unterschiedlichen Gehalt an Stickstoff und/oder Sauerstoff- und/oder Carbid hat.

In der zweiten Schicht kann sich der Gehalt an Stickstoff und/oder Sauerstoff und/oder Kohlenstoff, ausgehend vom Gehalt der ersten Schicht, kontinuierlich verändern in Abhängigkeit von einem Ortsabstand zur ersten Schicht.

Der Schichtaufbau kann

- eine Diffusion von Ionen hemmen,
- einen Netzwerkangriff gegen die Substratoberfläche und/oder einen hydrolytischen Angriff gegen die Schutzschicht verhindern,
- eine proteinabweisende und algenabweisende Wirkung haben,
- die Reinigbarkeit der Oberfläche verbessern aufgrund einer hohen Säure- und Alkalibeständigkeit.

Die Schutzschicht kann eine Zusammensetzung haben, die sich als sehr vorteilhaft erwiesen hat. Im Folgenden werden die Optionen der Zusammensetzung beschrieben.

Das Verhältnis Kohlenstoff zu Silizium kann einen Wert haben, der vorliegend als alpha =x/w bezeichnet wird. Hierbei gilt:

- $Si_{w1}C_{x1}$: $O_{y1}H_{z1}N_{n1}$ = Zusammensetzung der ersten Schicht, und

- $Si_{w2}C_{x2}$: $O_{y2}H_{z2}N_{n2}$ = Zusammensetzung der zweiten Schicht
  wobei

      w= Stoffmenge von Si,
      x= Stoffmenge von C,
      y= Stoffmenge von O,
      z= Stoffmenge von H,
      n= Stoffmenge von N.

Das Verhältnis "alpha" von Kohlenstoff zu Silizium kann einen Wert in dem Bereich

- 0,8 < alpha < 7, oder
- 2,5 < alpha < 5, oder
- 3,1 < alpha < 5

aufweisen.

Das Verhältnis "beta" von Stickstoff zu Silizium kann einen Wert in dem Bereich

- 0 < beta < 3, oder
- 0 < beta < 0,5, oder
- 0 < beta < 0,1

aufweisen, wobei beta =n/w.

Der Kohlenstoffanteil "c1(C)" in der ersten Schicht kann einen Wert von

- c1(C) >= 40%, oder
- c1(C) >= 45%, oder
- c1(C) >= 50%

aufweisen, wobei c1(C) = x1 / (w1+x1+y1+z1+n1).

Der Stickstoffanteil "c2(N)" in der zweiten Schicht kann einen Wert von

$$c2(N) >= 0,1\%,$$

aufweisen, wobei c2(N) = n2 / (w2+x2+y2+z2+n2).

Der Stickstoffanteil "c1(N)" in der ersten Schicht kann einen Wert von

- c1(N) >= 0,01%, oder
- c1(N) >= 0,05%

aufweisen, wobei c1(N) = n1 / (w1+x1+y1+z1+n1).

Der Sauerstoff-Anteil "c2(0)" in der zweiten Schicht kann einen Wert von

- c2(O) >= 5%, oder
- c2(O) >= 10%, oder
- c2(O) >= 15%

aufweisen, wobei c2(O) = y2 / (w2+x2+y2+z2+n2).

Die zweite Schicht kann bezüglich Stickstoff, Sauerstoff und/oder Kohlenstoff eine Dichte von

- d2 > 1,7 g/cm3, oder

- d2 > 1,65 g/cm3

aufweisen.

Die dargestellten Merkmale der der Schutzschicht-Zusammensetzung tragen jeweils dazu bei, dass

- das Verbundmaterial biokompatibel ist,
- das Verbundmaterial proteinabweisend und/oder algenabweisend ist,
- die Protein-Adsorption gegenüber einem unbeschichteten Glassubstrat geringer ist, vorzugsweise um wenigstens 5% oder 10%.

Die zweite Schicht kann eine geringere Dicke als die erste Schicht aufweisen.

Die Schutzschicht kann eine Uniformitätszahl "U" haben, wobei

- U > 0,5 oder
- U > 0,6 oder
- U > 0,7.

Hierbei gilt

U = Dmin / Dmax,
Dmin = kleineste Schichtdicke,
Dmax = größte Schichtdicke.

Die gesamte Dicke "D" der Schutzschicht kann in einem Größenbereich liegen von

- 0,5 nm < D < 500 nm, oder
- 1 nm < D < 200 nm, oder
- 10 nm < D <= 75 nm.

Gemäß einer Ausführungsform kann die Schutzschicht mittels eines gepulsten Mikrowellen CVD-Plasmas auf das Substrat abgeschieden werden. Das Verfahren hat mehrere Vorteile:

- Die dadurch hergestellte Schicht ist in hohem Maße defektfrei und weist damit eine verbesserte Diffusionsbarriere-Wirkung.
- Bei der Innenbeschichtung von Hohlkörpern ergibt es eine oberflächenkonforme, chemisch und physikalisch homogene beschichtete Innenoberfläche.
- Durch dieses Verfahren kann die Schichtdicke im Bereich der Kontaktfläche exakt gestaltet werden, so dass auch eine hohe Schichtdicke und eine damit verbundene hohe Barrierewirkung erzielbar sind.

Gemäß einer Ausführungsform kann das Verbundmaterial wenigstens eines oder eine Kombination aus folgenden Materialien enthalten:

- Aluminiumoxid, Aluminiumnitrid oder Aluminiumoxinitrid,
- Zirkonoxid, Zirkonnitrid oder Zirkonoxinitrid,
- Titanoxid, Titanoxinitrid, Titannitrid,
- hydrogenisiertes Zirkonoxid, Zirkonnitrid oder Zirkonoxinitrid,
- hydrogenisiertes Titanoxid, Titanoxinitrid, Titannitrid,
- hydrogenisiertes Siliziumoxid,

Das Verbundmaterial kann eines der vorstehend genannten Materialien enthalten mit einem zusätzlichem KohlenstoffGehalt von

- wenigstens 0,1% und maximal 30%, oder vorzugsweise
- wenigstens 0,5% und maximal 25%, oder insbesondere
- wenigstens 1% und maximal 20%.

Ein weiterer Aspekt der Erfindung betrifft ein Verbundmaterial, das vorzugsweise für ein pharmazeutisches Packmittel verwendbar ist, und das ein Substrat und eine Schutzschicht umfasst.

Das Substrat kann einen Kontaktbereich mit der Schutzschicht aufweisen, welcher die Kontaktfläche zwischen Substrat und Schutzschicht, sowie einen oberflächennahen Bereich der Schutzschicht umfassen. Das Substrat kann aus einem Cycloolefinpolymer oder einem Cycloolefincopolymer bestehen.

Die Beschaffenheit des Substrats im Kontaktbereich kann verschieden sein von der Beschaffenheit des Substrats außerhalb des Kontaktbereichs.

Die Schutzschicht kann aus einem keramischen Material ausgebildet sein und kann einen oder mehrere der folgenden Stoffe oder Bindungen enthalten:

- Siliziumcarbid SiC;
- hydrogenisiertes oxydiertes Siliziumcarbid SiC:OH;
- nitriertes oxidiertes hydrogenisiertes Siliziumcarbid SiC:OHN;
- Stickstoff;
- N-H-Bindungen oder C-N-Bindungen.

In Verbindung mit dem Substrat aus Cycloolefin-Polymer oder Cycloolefin-Copolymer kann der Kontaktbereich die Elemente Si und O, oder Si,O,C und H enthalten.

Vor dem Abscheiden der Schutzschicht kann das Substrat vorgeheizt werden, vorzugsweise mittels eines Plasmaprozesses. Das Vorheizen des Substrats kann, aufgrund der höheren Substrattemperatur und der erhöhten Oberflächendiffusion eine geringere Defektdichte der Schicht bewirken.

Andererseits können durch dieses Verfahren die mechanischen Spannungen so weit reduziert werden, dass der Verbund aus Glassubstrat und Schicht besonders temperaturbeständig ist. Dies hängt damit zusammen, dass höhere Temperaturbelastungen ab einem kritischen Wert zu Rissen oder Schichtablösungen führen können aufgrund der mit unterschiedlichen Ausdehungskoeffizienten zwischen Schicht und Substrat zusammenhängenden thermischen Spannungen.

Vor dem Abscheiden der Schutzschicht kann eine Plasma-Oberflächenbehandlung der Glasoberfläche durchgeführt werden, wodurch eine bessere Anbindung der Schutzschicht an das Glassubstrat erreicht wird.

Nach dem Abscheiden der Schutzschicht kann das beschichtete Substrat bei einer Temperatur T > 240°, vorzugsweise während einer Zeit t > 3 Minuten thermisch nachbehandelt werden. Die Nachbehandlung kann die Einwirkung eines Sauerstoff- und Stickstoff-haltigen Gasgemisches auf die oberflächennahe Zone der Schutzschicht, das heißt auf den Kontaktbereich, umfassen.

Damit kann auf einfache Weise Stickstoff in der Schichtoberfläche eingebaut werden.

Nach dem Abscheiden der Schutzschicht kann das beschichtete Substrat oxidiert werden, wobei zunächst das Plasma abgeschaltet und anschließend ein sauerstoffhaltiges Gas zum Nachnitrieren und/oder Nachoxidieren zugeführt wird.

Vorteilhafter Weise kann dadurch die Oberfläche auf einfache Weise nachtriert bzw. nachoxidiert werden kann, was keinen weiteren Einsatz von Energie erfordert.

Eine SiC:OHN - Schutzschicht kann durch Plasma-Polymerisation eines Gasgemisches mit einem Silan-basierten Precursor abgeschieden werden, bei dem ein oberflächennaher Bereich nach Abscheidung der Schicht durch Kontakt mit einem Stickstoff-haltigen Gas optional nachbehandelt wird, wodurch der Stickstoff-Anteil in diesem Bereich erhöht wird.

Gemäß einer Ausführungsform kann ein Gasgemisch verwendet werden, das Stickstoff oder eine Stickstoff haltige Verbindung enthält.

Insbesondere kann ein Gasgemisch aus Silan und Sauerstoff verwendet werden.

Stickstoff kann als Verunreinigung der Ausgangsverbindungen vorliegen. Die Stickstoff-Menge kann durch den Restgasanteil bestimmt werden.

Stickstoff kann in einem Vakuumprozess, mittels eines Restgasanteils, über die Leckrate dosiert werden.

Die Leckrate des Restgasanteils kann in einem Bereich

$$9 \times 10^{-1} - 1{,}5 \times 10^{-4} \text{ mbar l/s}$$

liegen.

Stickstoff kann in alle Schichten der Schutzschicht eingefügt werden.

Auf Basis der geschilderten Vorgehensweise kann die Prozessführung vereinfacht werden, da kein zusätzlicher Aufwand für weiteres Prozessgas benötigt wird.

Es kann eine SiC oder SiC:OH Schutzschicht unter Zersetzung eines Disilan-Precursors abgeschieden werden.

Als Precursor kann ein Gas mit einer Si-Si Bindung, oder ein Disilan, oder ein Hexamethyldisilan verwendet werden.

Es können Pulse mit variablen Pulsdauern und/oder Pulspausen verwendet werden.

Die Prozesstemperatur kann in einem Bereich

- 25°C - 400°C oder
- 30°C - 300°C

liegen.

Gemäß einer Ausführungsform kann der Plasmaprozess mittels eines Photodetektors überwacht werden.

Eine Fragmentierung der Si-Si-Bindung kann über eine durch einen Filter selektierte optische Inspektion überwacht werden.

Eine Substrattemperatur kann durch eine Thermokamera überwacht werden.

Gemäß einer Ausführungsform kann ein Hohlkörper, dessen Wand aus dem erfindungsgemäßen Verbundmaterial besteht, für eine Vielzahl flüssiger Produkte verwendet werden.

Unter anderen, kann der Hohlkörper verwendet für

- Produkte mit alkalischen Wirkstoffen, und/oder Protein-basierten Wirkstoffen, und/oder
- Produkte mit oberflächenaktiven Tensiden, die auch als 'Surfactants' bekannt sind, und/oder
- ungepufferte Medikamentenlösungen, und/oder
- saure oder neutrale oder alkalische Formulierungen, die insbesondere wenigstens ein Surfactant oder Tensid enthalten, und/oder
- Lösungen, bei denen das Surfactant aus Polysorbat, beispielsweise Tween20 oder Tween80 oder Pluronics, besteht, und/oder
- Lösungen, die Zucker oder Zuckeralkohol enthalten.

Das Verbundmaterial verhindert, bei Verwendung in einem Behälter in dem ungepufferte Medikamentenlösungen gelagert sind, eine Verschiebung des pH-Werts des gelagerten Produkts aus dem zulässigen Toleranzbereich.

Ein Behälter, dessen Wand aus dem erfindungsgemäßen Verbundmaterial besteht, kann auf vorteilhafte Weise in diversen Prozessen verwendet werden.

Unter anderen, kann der Behälter in einem Prozess verwendet werden, der einen oder mehrere der folgenden Schritte umfasst:

- der Behälter wird vor der Abfüllung gewaschen,
- der Behälter wird mit einer wässrigen Lösung gewaschen, die Reinigungsmittel oder Detergenzien umfasst,
- der Behälter wird mit einem sauren oder alkalischen Reiniger gewaschen.

Zusammengefasst hat die Schutzschicht eine Vielzahl vorteilhafter Wirkungen:

- Diffusionssperre gegen Ionenaustausch zwischen einer flüssigen, vorzugsweise wässrigen Lösung und der Glasmatrix,
- Diffusionssperre gegen chemischen Angriff des SiO2-Netzwerks des Glases,
- Diffusionssperre gegen alle Elemente der Glasmatrix, wie Natrium, Kalium, Silizium, Bor, Calcium, Aluminium, Zirkon,
- Resistenz gegen chemischen Angriff im alkalischen pH-Bereich,
- Resistenz gegen chemischen Angriff im sauren und neutralen pH-Bereich, vorzugsweise im gesamten pH-Bereich zwischen pH 1 - 12,
- Erzeugung einer Schichtmorphologie mit geringer Defektdichte.

Die Erfindung wird nachfolgend anhand von Ausführungsbeispielen und unter Bezugnahme auf die Zeichnungen näher erläutert. Dabei verweisen gleiche Bezugszeichen auf gleiche oder entsprechende Elemente. Die Merkmale verschiedener Ausführungsbeispiele können miteinander kombiniert werden.

Kurzbeschreibung der Figuren

Es zeigen:

Fig. 1    eine Schnittdarstellung einer ersten Ausführungsform des Verbundmaterials,

Fig. 2    eine Schnittdarstellung einer zweiten Ausführungsform des Verbundmaterials,

Fig. 3    ein mittels TOFSIMS erstelltes Intensitätssputterzeitprofil des in einem ersten Ausführungsbeispiel des Herstellverfahrens erhaltenen Verbundmaterials,

Fig. 4    ein mittels TOFSIMS erstelltes Intensitätssputterzeitprofil des in einem zweiten Ausführungsbeispiel des Herstellverfahrens erhaltenen Verbundmaterials,

Fig. 5 ein mittels Ellipsometrie ermittelter Verlauf von Brechungsindex und Extinktionskoeffizient.

Detaillierte Beschreibung der Erfindung

Bei der Lagerung von flüssigen Wirkstoffformulierungen in Pharmapackmitteln aus Glas kann es in Verbindung mit Puffern, wie beispielsweise Phosphat- und Citratpuffern oder von Salz-haltigen Lösungen und weiteren Formulierungsbestandteilen während der Lagerung zu einer Glas-Delamination, d.h. zu einer partiellen Auslösung von Glasflittern, kommen. Diese Delamination ist ein aktuelles Problem der pharmazeutischen Industrie und fortlaufend werden neue Fälle von Glas-Delamination bekannt.

Auf überraschend einfache Weise lässt sich Glas-Delamination durch eine Beschichtung vermeiden oder zumindest reduzieren. Die Beschichtung verhindert einerseits einen korrosiven Angriff des Glassubstrats und ist andererseits als Schicht selbst korrosionsbeständig, wodurch eine Auflösung der Schicht selbst durch einen chemischen Angriff, beispielsweise durch einen hydrolytischen Angriff, verhindert wird. Dadurch wird eine verbesserte Stabilität des Produkts im Pharmapackmittel erreicht.

Ferner ermöglicht die Beschichtung auch eine längere Lagerdauer des Behälters in Kombination mit einer verbesserten Produktsicherheit.

Insbesondere geht es dabei um eine Reduktion des Risikos für die pharmazeutische Industrie und um eine Lösung, die auf verschiedensten inhomogenen Glasoberflächen von Gläsern mit hydrolytischer Klasse I, aber auch Gläsern mit hydrolytischer Klasse II - V wirksam ist und für ein möglichst breites Spektrum an Pufferlösungen und Formulierungsvarianten anwendbar ist.

Das Verbundmaterial 1 kann für eine Vielfalt von Prozessvarianten beim Sterilisieren bzw. Depyrogenisieren und beim Reinigen der Fläschchen eingesetzt werden.

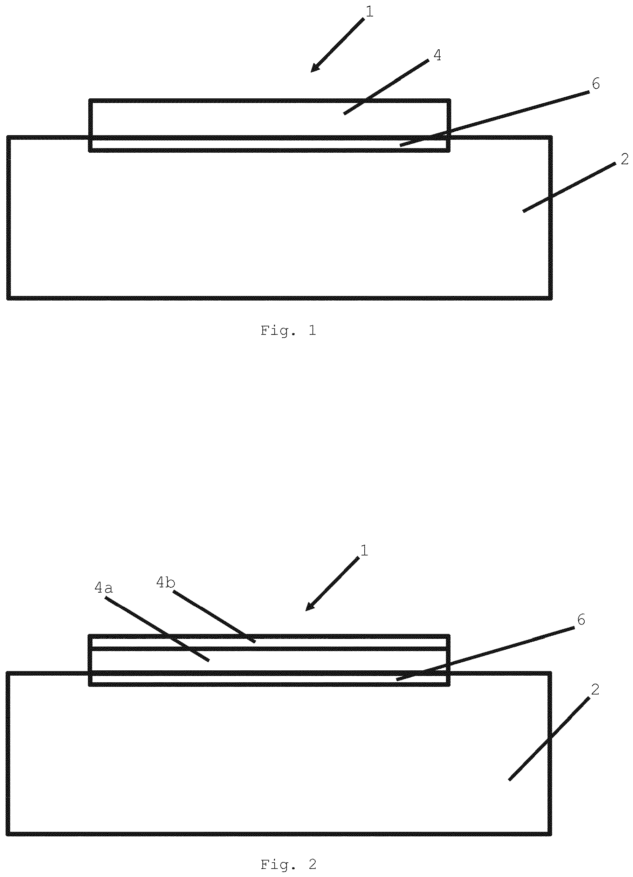

Die Fig. 1 zeigt ein Verbundmaterial 1 für ein pharmazeutisches Packmittel gemäß einem ersten Ausführungsbeispiel. Das Verbundmaterial 1 umfasst ein Substrat 2 und eine Schutzschicht 4.

Das Substrat 2 weist einen Kontaktbereich 6 mit der Schutzschicht 4 auf. Der Kontaktbereich 6 umfasst die Kontaktfläche zwischen Substrat 2 und Schutzschicht 4, sowie einen oberflächennahen Bereich der Schutzschicht 4

Das Substrat 2 ist aus Glas ausgebildet. Das Substrat 4 ist vorliegend als ein Flachsubstrat oder Glasscheibe ausgebildet.

Die Schutzschicht 4 besteht aus Keramik.

Bei der Lagerung eines flüssigen Produkts in einem Behälter aus Glas kann es während der Lagerung zu einer Glas-Delamination, d.h. zu einer partiellen Auslösung von Glasflittern, kommen.

Durch die Schutzschicht kann vorteilhafter Weise eine Anti-Delaminations-Wirkung und eine verbesserte Schichtbeständigkeit erzielt werden, sofern der Behälter zur Lagerung des Produkts aus dem Verbundmaterial ausgebildet ist.

Die Schutzschicht 4 ist vorteilhafter Weise kovalent an die Oberfläche des Kontaktbereichs 1 angebunden.

Die Schutzschicht 4 und deren kovalente Anbindung an die Oberfläche des Kontaktbereichs 6 kann vorteilhafter Weise eine Diffusion von Ionen hemmen. Dadurch kann ein Auslösen von Substratbestandteilen durch eine chemische Wechselwirkung zwischen dem Produkt und dem Substrat 2 verhindert werden.

Das Verbundmaterial 1 weist auf diese Weise einen gegenüber einem konventionellen Glassubstrat verbesserten Korrosionsschutz auf.

Die Fig. 2 zeigt ein Verbundmaterial 1 für ein pharmazeutisches Packmittel gemäß einem zweiten Ausführungsbeispiel. Das Verbundmaterial 1 umfasst ein Substrat 2 und eine Schutzschicht 4a, 4b.

Im Unterschied zum ersten Ausführungsbeispiel gemäß Fig. 1 weist die Schutzschicht zwei Schichten 4a, 4b auf. Hierbei ist eine erste Schicht 4a als Basisschicht ausgebildet und eine zweite Schicht 4b ist als oberflächennahe Schicht ausgebildet.

Die zweite Schicht 4b hat eine gegenüber der ersten Schicht 4a unterschiedliche Zusammensetzung, wobei die zweite Schicht 4b einen gegenüber der ersten Schicht 4a unterschiedlichen Gehalt an Stickstoff und/oder Sauerstoff- und/oder Carbid hat.

Das Verbundmaterial der Erfindung kann auch für KunststoffBehälter mit einem Substrat aus Cycloolefinpolymer (COP) oder Cycloolefincopolymer (COC) zum Bilden einer korrosionsresistenten Barriere-Schicht eingesetzt werden, beispielsweise für Fläschchen aus COP oder COC als auch Spritzenkörper oder Karpulenkörper aus COP oder COC. Die erfindungsgemäße Beschichtung haftet auf diesen Kunststoffen fest, mit äußerst geringer oder nicht vorhandener Delaminationsneigung.

Auf den Cycloolefinpolymeren wird dabei eine Schicht abgeschieden, die einen oder mehrere der folgenden Stoffe oder Bindungen enthält:

- Siliziumcarbid SiC;

- hydrogenisiertes oxydiertes Siliziumcarbid SiC:OH
- nitriertes oxidiertes hydrogenisiertes Siliziumcarbid SiC:OHN
- Stickstoff
- N-H-Bindungen oder C-N-Bindungen

Erstes Ausführungsbeispiel des Herstellverfahrens

Zwei Fläschchen aus Borosilikat-Glas (SCHOTT-Fiolax), mit 10ml Füllvolumen und 14ml Randvoll-Volumen, werden in einen Plasma-Beschichtungsreaktor mit einer Doppelkammer zugeführt und dabei jeweils auf der Unterseite des Reaktors auf eine Dichtfläche gesetzt.

Anschließend werden die Reaktorkammern geschlossen und der Innenraum der Fläschchen auf einen Basisdruck < 0,lmbar evakuiert. Der Außenraum bleibt während des gesamten Behandlungsvorgangs auf Atmosphärendruck. Während untenseitig im Bereich der Öffnung der Fläschchen die Verbindung zum Vakuum beibehalten bleibt, wird das Gaseinlass-Ventil geöffnet und über die Gaszuführung als erstes Prozessgas Argon eingeleitet.

Mittels einer Mikrowellenquelle wird anschließend gepulste Mikrowellen-Energie mit einer Frequenz von 2,45 GHz eingekoppelt und ein Plasma gezündet. Das Substrat wird mit dem Plasma auf eine Temperatur oberhalb von 200°C aufgeheizt. Nachfolgend wird in einer Gaswechselzeit ein Gemisch aus Hexamethyldisilan und Argon mit einer Konzentration von Hexamethyldisilan von 5% bezogen auf einen Gesamtfluss von 50sccm eingeleitet und ein Prozessdruck von 0,3mbar eingestellt und mittels gepulstem Mikrowellenplasma (mittlere Mikrowellenleistung von 340W) und einer Pulspause von 30ms in einer Beschichtungszeit von 3s eine 25 nm dicke hydrogenisierte, oxidierte, nitrierte Siliziumcarbid-Schicht abgeschieden.

Nach dem Beschichtungsvorgang werden die Fläschchen durch ein Ventil von der Vakuumquelle getrennt und mittels Stickstoffgas aus Atmosphärendruck geflutet und aus der Beschichtungsanlage entnommen.

Zweites Ausführungsbeispiel des Herstellverfahrens

Analog zu erstes Ausführungsbeispiel des Herstellverfahrens werden zwei Fläschchen vom gleichen Format zu Beginn des Prozesses aufgeheizt, jedoch wird anschließend in der Gaswechselzeit ein Gemisch aus Hexamethyldisilan, Sauerstoff und Argon mit einer Konzentration von 35% Hexamethyldisilan, 60% Sauerstoff und 5% Argon bezogen auf den Gesamtfluss eingeleitet und mit gleichen Plasmaparametern wie beim ersten Ausführungsbeispiel des Herstellverfahrens eine 50nm dicke hydrogenisierte, oxidierte, nitrierte Siliziumcarbid-Schicht hergestellt.

Analysen

Nach der Herstellung von weiteren beschichteten Fläschchen mit dem gleichen Verfahren jeweils entsprechend dem ersten und zweiten Ausführungsbeispiel des Herstellverfahrens werden an den beschichteten Proben und an unbeschichteten Referenzen folgende Funktionstests durchgeführt:

1. Bestimmung der Natriumauslaugung nach Autoklavieren für eine Dauer von 6 Stunden bei 121°C mit verschiedenen Puffersystemen (verschlossene Fläschchen, Füllvolumen 12,4ml)
2. Bestimmung der Siliziumauslaugung nach Autoklavieren für eine Dauer von
3. 6 Stunden bei 121°C mit verschiedenen Puffersystemen (verschlossene Fläschchen, Füllvolumen 12,4ml)

Die Bestimmung der Natrium- und Silizium-Abgabe der Innenoberfläche der beschichteten Behältnisse erfolgt in Anlehnung an ISO 4802-2. Für die Befüllung zum Autoklavieren werden folgende Puffersysteme verwendet:

- pH 1: HCl c = 0,1 mol/L
- pH 7: Tris(hydroxymethyl)-aminomethan/Maleinsäure-Puffer, mit KOH eingestellt auf pH 7
- pH 9: Tris(hydroxymethyl)-aminomethan-Puffer, mit HCl eingestellt auf pH 9

Es ergaben sich für verschiedene Proben folgende Werte gemäß Tabelle 1.

| Funktionstest / Ausführung | Ak 6h 121°C 0,1M HCl Na [mg/L] | Ak 6h 121°C 0,1M HCl Si [mg/L] | Ak 6h 121°C TRIS pH7 Na [mg/L] | Ak 6h 121°C TRIS pH7 Si [mg/L] | Ak 6h 121°C TRIS pH9 Na [mg/L] | Ak 6h 121°C TRIS pH9 Si [mg/L] |
|---|---|---|---|---|---|---|
| Beispiel 1 | 0,04 | 0,16 | 0,00 | 0,07 | 0,01 | 0,06 |
| Beispiel 2 | 0,05 | 0,08 | - | - | 0,03 | 0,05 |
| Referenz 10ml Vial | 2,64 | 6,27 | 0,42 | 1,52 | 0,70 | 2,34 |

Tabelle 1: Auslaugungswerte von Natrium und Silizium nach Autoklavieren (6 Stunden bei 121°C) mit verschiedenen Puffersystemen und pH-Werten

Die Test-Ergebnisse ergeben folgendes:

1. Die Schichten besitzen eine hohe Barriere-Wirkung oder Schutz-Wirkung gegen Ionenaustausch von Natrium Ionen zwischen der Fiolax-Glasmatrix und den wässrigen Lösungen.
2. Die Schichten besitzen ferner eine hohe Barriere-Wirkung gegen eine Auslösung von Silizium aus dem Glas.
3. Die Schichten selbst sind beständig gegen einen chemischen Angriff. Denn wären die Schichten nicht stabil, so würde bei einem Angriff der Schicht in größeren Mengen Silizium aus dem Siliziumcarbid-haltigen Schichtsystem ausgelöst.
4. Alle Aussagen gelten für einen breiten pH-Bereich von pH 1 bis pH 9, d.h. die Schichten verhindern sowohl einen Ionenaustausch im sauren pH-Bereich, als auch einen Angriff des Glasnetzwerks im alkalischen pH-Bereich.
5. Ferner weisen die Schichten selbst auch eine ausgezeichnete chemische und insbesondere hydrolytische Beständigkeit für diesen breiten pH-Bereich auf. Insbesondere im alkalischen pH-Bereich weisen die Schichten eine hohe Resistenz gegen einen Netzwerkangriff der Schicht selbst auf.

Weitere entsprechend den Ausführungsbeispielen 1 und 2 des Herstellverfahrens hergestellte Proben werden mittels Time of Flight Sekundärionenmassenspektrometrie (TOF-SIMS)-Analyse (negative Ionen) und XPS (unter 2 Kippwinkeln) analysiert.

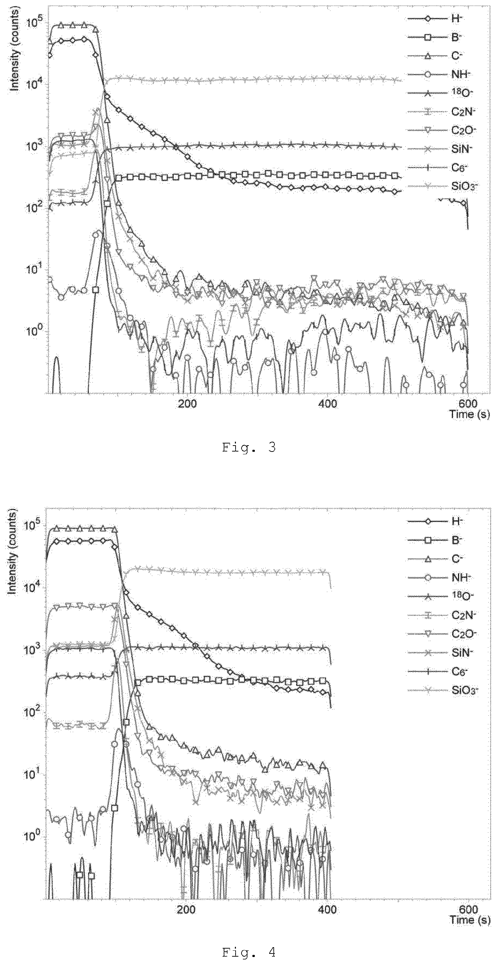

Das zweite Ausführungsbeispiel des Herstellverfahrens zeigt im Intensitätssputterzeitprofil entsprechend Fig.4 und XPS Analyse entsprechend Tabelle2, unter "Beispiel2" einen höheren Sauerstoff-Anteil als beim Ausführungsbeispiel1, mit Intensitätssputterzeitprofil entsprechend Fig.3 und XPS-Analyse entsprechend Tabelle2, unter "Beispiel1" was durch den als zusätzliches Prozessgas zugeführten Sauerstoff verursacht ist. Dabei wird durch den lateralen Verlauf der Intensitätssputterzeitprofile in Fig.4 und Fig.3 bestätigt, dass die Schichten aus den Ausführungsbeispielen 1 und 2 des Herstellverfahrens unterschiedlich dick sind, was unter anderem durch die unterschiedlichen Sputterzeiten bis zum Abfall der C-Signals erkennbar ist, der den Übergang von der Schicht ins Substrat beschreibt.

Die Fig. 3 zeigt ein mittels TOFSIMS aufgenommenes Intensitätssputterzeitprofil gemäß dem ersten Ausführungsbeispiel des Herstellverfahrens.

Die Fig. 4 zeigt ein mittels TOFSIMS aufgenommenes Intensitätssputterzeitprofil gemäß dem zweiten Ausführungsbeispiel des Herstellverfahrens.

Tabelle 2: XPS Analysen des ersten und zweiten Ausführungsbeispiels des Herstellverfahrens

| Ausführung | Winkel (°) | C[at%] | N[at%] | O[at%] | Si[at%] | C/Si | O/Si | N/Si |
|---|---|---|---|---|---|---|---|---|
| Beispiel 1 | 0 | 63,2 | 0,6 | 18,1 | 18,1 | 3,5 | 1,0 | 0,03 |
| | 50 | 63 | 0,4 | 19,5 | 17 | 3,7 | 1,1 | 0,02 |
| Beispiel 2 | 0 | 54,8 | 0 | 26,6 | 18,7 | 2,9 | 1,4 | 0,00 |
| | 50 | 56,2 | 0,1 | 26,5 | 17,3 | 3,2 | 1,5 | 0,01 |

Ferner zeigen die sowohl die Intensitätssputterzeitprofile durch den Verlauf und Sprung der NH⁻, SiN⁻ und C$_2$N⁻

- Signale und in guter Übereinstimmung mit den XPS-Analysen, dass in geringen Mengen Stickstoff mit in die Schichten eingebaut wird. Der Stickstoff-Anteil ist dabei im gesamten Intensitätssputterzeitbereich des Tiefenprofils zu finden, der der Schicht entspricht. Denn erst wenn das $C^-$-Signal für Kohlenstoff abfällt, fallen auch diese Signale simultan im Bereich des Interfaces zum Substrat ab.

Drittes Ausführungsbeispiel des Herstellverfahrens

Analog zu den Ausführungsbeispielen 1 und 2 des Herstellverfahrens werden Fläschchen beschichtet, jedoch zuvor mit einem Stickstoff-haltigen Plasma auf Prozesstemperatur vorgeheizt. Die beschichteten Fläschchen zeigen eine gute Barriere-Wirkung gegen eine Auslaugung von Natrium-Ionen und Silizium aus dem Glas und eine hohe Schichtbeständigkeit analog zu den Ausführungsbeispielen 1 und 2.

Viertes Ausführungsbeispiel des Herstellverfahrens

Analog zu den Ausführungsbeispielen 1 und 2 des Herstellverfahrens werden Glasspritzenkörper in einem Plasma-Spritzen-Beschichtungsreaktor, jedoch in einer Einzelplatzkammer, mit hydrogenisiertem oxidiertem, nitriertem Siliziumcarbid-Schicht in einem analogen Verfahren beschichtet. Die beschichteten Spritzen zeigen eine gute Barriere-Wirkung gegen eine Auslaugung von Natrium-Ionen und Silizium aus dem Glas und eine hohe Schichtbeständigkeit analog zu den Ausführungsbeispielen 1 und 2 des Herstellverfahrens.

Gemäß den obigen Ausführungsbeispielen analog hergestellte Schichten wurden bezüglich Brechungsindex und Extinktionskoeffizient mittels Ellipsometrie als Funktion der Wellenlänge gemessen.

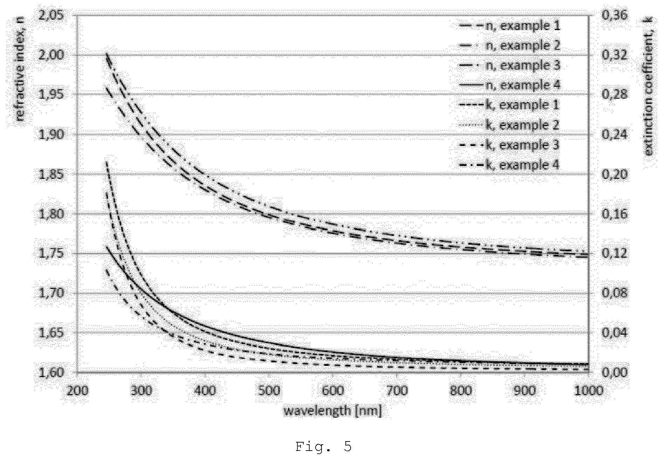

Der ermittelte Verlauf ist in Fig. 5 gezeigt. Auf der Abszissenachse ist die Wellenlänge, auf der linken Ordinatenachse ist der Brechungsindex n und auf der rechten Ordinatenachse ist der Extinktionskoeffizient k aufgetragen.

Hier ist ersichtlich, dass die Schutzschicht eine wellenlängenabhängige Absorption aufweist, wobei der Extinktionskoeffizient ab einer Wellenlänge von 500nm bis zu einer Wellenlänge von 250nm mit abnehmender Wellenlänge ansteigt, wobei der Anstieg wesentlich steiler als ein linearer Anstieg ist.

Bezugszeichen

1    Verbundmaterial
2    Substrat
4    Schutzschicht
4a   erste Teilschicht der Schutzschicht
4b   zweite Teilschicht der Schutzschicht
6    Kontaktbereich

**Patentansprüche**

1. Verbundmaterial für ein pharmazeutisches Packmittel, umfassend ein Substrat (2) und eine Schutzschicht (4), wobei

    - das Substrat (2) einen Kontaktbereich (6) mit der Schutzschicht (4) aufweist, welcher die Kontaktfläche zwischen Substrat (2) und Schutzschicht (4), sowie einen oberflächennahen Bereich der Schutzschicht (4) umfasst,
    - das Substrat (2) aus Glas oder einem Cycloolefinpolymer oder einem Cycloolefincopolymer ausgebildet ist,
    - die Beschaffenheit des Substrats (2) im Kontaktbereich (6) verschieden ist von der Beschaffenheit des Substrats (2) außerhalb des Kontaktbereichs (6), wobei die Beschaffenheit mindestens eines von: eine Oberflächenrauigkeit, eine chemische Zusammensetzung, eine Oberflächenenergie, eine chemische Ätzrate des Substrats (2) betrifft, und
    - die Schutzschicht (4) aus einem keramischen Material ausgebildet ist.

2. Verbundmaterial nach Anspruch 1, **gekennzeichnet durch** mindestens eines der folgenden Merkmale:

    - das Substrat (2) ist aus Glas der hydrolytischen Klasse I-V ausgebildet;
    - das Substrat (2) ist aus Borosilikat-Glas der hydrolytischen Klasse I ausgebildet.

3. Verbundmaterial nach einem der Ansprüche 1 oder 2, **gekennzeichnet durch** mindestens eines der folgenden Merkmale:

    - die Oberflächenrauigkeit des Substrats (2) im Kontaktbereich (6) ist verschieden von der Oberflächenrauigkeit des Substrats (2) außerhalb des Kontaktbereichs (6);
- die chemische Zusammensetzung des Substrats (2) im Kontaktbereich (6) ist verschieden von der chemischen Zusammensetzung des Substrats (2) außerhalb des Kontaktbereichs (6);
- die Oberflächenenergie des Substrats (2) im Kontaktbereich (6) ist verschieden von der Oberflächenenergie des Substrats (2) außerhalb des Kontaktbereichs (6);
- die chemische Ätzrate des Substrats (2) im Kontaktbereich (6) ist verschieden von der chemischen Ätzrate des Substrats (2) außerhalb des Kontaktbereichs (6).

4. Verbundmaterial nach einem der vorhergehenden Ansprüche, **gekennzeichnet durch** mindestens eines der folgenden Merkmale:

- die Schutzschicht (4) ist über van-der Waals-Kräfte und/oder kovalent an die Oberfläche des Substrats (2) angebunden;
- die Schutzschicht (4) ist amorph, insbesondere teil-kristallin oder kristallin, vorzugsweise aus der Gasphase abgeschieden;
- die Schutzschicht (4) ist zumindest in einem Teilbereich frei von Siliciumdioxid (SiO2).

5. Verbundmaterial nach einem der vorhergehenden Ansprüche, **gekennzeichnet dadurch, dass** die Schutzschicht (4) einen oder mehrere der folgenden Stoffe oder Bindungen enthält:

- Siliziumcarbid SiC;
- hydrogenisiertes oxydiertes Siliziumcarbid SiC:OH;
- nitriertes oxidiertes hydrogenisiertes Siliziumcarbid SiC:OHN;
- Stickstoff;
- N-H-Bindungen oder C-N-Bindungen.

6. Verbundmaterial nach einem der vorhergehenden Ansprüche, **gekennzeichnet durch** mindestens eines der folgenden Merkmale:

- die Schutzschicht (4) weist zwei Teilschichten (4a, 4b) auf, wobei eine erste Schicht (4a) als Basisschicht ausgebildet ist und eine zweite Schicht (4b) als oberflächennahe Schicht ausgebildet ist;
- die zweite Schicht (4b) hat eine gegenüber der ersten Schicht (4a) unterschiedliche Zusammensetzung;
- die zweite Schicht (4b) hat einen gegenüber der ersten Schicht (4a) unterschiedlichen Gehalt an Stickstoff und/oder Sauerstoff und/oder Kohlenstoff;
- in der zweiten Schicht (4b) verändert sich der Gehalt an Stickstoff und/oder Sauerstoff und/oder Kohlenstoff, ausgehend vom Gehalt der ersten Schicht (4a), kontinuierlich in Abhängigkeit von einem Ortsabstand zur ersten Schicht (4a).

7. Verbundmaterial nach einem der vorhergehenden Ansprüche, **gekennzeichnet durch** mindestens eines der folgenden Merkmale:

- das vorzugsweise mittels X-ray Photoelectron Spectrometry (XPS) bestimmte Verhältnis alpha = Anteil Kohlenstoff zu Anteil Silizium in der Schutzschicht weist einen Wert in dem Bereich 0,8 < alpha < 7, oder 2,5 < alpha < 5, oder 3,1 < alpha < 5 auf;
- das vorzugsweise mittels X-ray Photoelectron Spectrometry (XPS) bestimmte Verhältnis beta = Anteil Stickstoff zu Anteil Silizium in der Schutzschicht weist einen Wert in dem Bereich 0 < beta < 3, oder 0 < beta < 0,5, oder 0 < beta < 0,1 auf;
- der Kohlenstoffanteil $c_1(C)$ in der ersten Teilschicht (4a) weist einen Wert $c_1(C) >= 40\%$, oder $c_1(C) >= 45\%$, oder $c_1(C) >= 50\%$ auf;
- der Stickstoffanteil $c_2(N)$ in der zweiten Schicht (4b) weist einen Wert $c_2(N) >= 0,1\%$ auf;
- der Stickstoffanteil $c_1(N)$ in der ersten Schicht (4a) weist einen Wert $c_1(N) >= 0,01\%$, oder $c_1(N) >= 0,05\%$ auf;
- der Sauerstoff-Anteil $c_2(O)$ in der zweiten Teilschicht (4b) weist einen Wert $c_2(O) >= 5\%$ oder $c_2(O) >= 10\%$ oder $c_2(O) >= 15\%$ auf;
- die zweite Teilschicht (4b) weist eine Stickstoffdichte, Sauerstoffdichte und/oder Kohlenstoffdichte > 1,7 g/cm3, oder > 1,65 g/cm3 auf.

8. Verbundmaterial, nach einem der vorstehenden Ansprüche, für ein pharmazeutisches Packmittel, umfassend ein Substrat (2) und eine Schutzschicht (4), wobei

- das Substrat (2) einen Kontaktbereich (6) mit der Schutzschicht (4) aufweist, welcher die Kontaktfläche zwischen Substrat (2) und Schutzschicht (4), sowie einen oberflächennahen Bereich der Schutzschicht (4) umfasst,
- das Substrat (2) aus einem Cycloolefinpolymer oder einem Cycloolefincopolymer ausgebildet ist,
- die Beschaffenheit des Substrats (2) im Kontaktbereich (6) verschieden ist von der Beschaffenheit des Substrats (2) außerhalb des Kontaktbereichs (6), wobei die Beschaffenheit mindestens eines von: eine Oberflächenrauigkeit, eine chemische Zusammensetzung, eine Oberflächenenergie, eine chemische Ätzrate des Substrats (2) betrifft, und wobei
die Schutzschicht (4) aus einem keramischen Material ausgebildet ist und einen oder mehrere der folgenden Stoffe oder Bindungen enthält:
- Siliziumcarbid SiC;
- hydrogenisiertes oxydiertes Siliziumcarbid SiC:OH;
- nitriertes oxidiertes hydrogenisiertes Siliziumcarbid SiC:OHN;
- Stickstoff;
- N-H-Bindungen oder C-N-Bindungen.

9. Verfahren zum Herstellen eines Verbundmaterials (1) mit einem Substrat (2) und einer Schutzschicht (4),

- wobei das Substrat (2) einen Kontaktbereich (6) mit der Schutzschicht (4) aufweist, welcher die Kontaktfläche zwischen Substrat (2) und Schutzschicht (4), sowie einen oberflächennahen Bereich der Schutzschicht (4) umfasst,
- wobei das Substrat (2) aus Glas ausgebildet ist und die Beschaffenheit des Substrats (2) in einem oberflächennahen Bereich des Substrats (2) verschieden ist von der Beschaffenheit des Substrats (2) außerhalb des oberflächennahen Bereichs und die Beschaffenheit mindestens eines von: eine Oberflächenrauigkeit, eine chemische Zusammensetzung, eine Oberflächenenergie, eine chemische Ätzrate des Substrats (2) betrifft, und
- wobei die aus einem keramischen Material ausgebildete Schutzschicht (4) mittels eines Plasmas auf das Substrat (2) abgeschieden wird.

10. Verfahren nach dem vorhergehenden Anspruch, umfassend mindestens einen der folgenden Schritte:

- die Schutzschicht (4) wird mittels eines gepulsten Mikrowellen CVD-Plasmas auf das Substrat (2) abgeschieden;
- vor dem Abscheiden der Schutzschicht (4) wird das Substrat (2) vorgeheizt, vorzugsweise mittels eines Plasmaprozesses;
- vor dem Abscheiden der Schutzschicht (4) wird eine Plasma-Oberflächenbehandlung der Glasoberfläche durchgeführt;
- nach dem Abscheiden der Schutzschicht (4) wird das beschichtete Substrat (2) bei einer Temperatur T > 240°C, vorzugsweise für eine Dauer t > 3 min, thermisch nachbehandelt;
- nach dem Abscheiden der Schutzschicht (4) wird das beschichtete Substrat (2) oxidiert, wobei zunächst das Plasma durch Unterbrechung der Energiezufuhr abgeschaltet und anschließend ein sauerstoffhaltiges Gas zum Nachoxidieren zugeführt wird.

11. Verfahren nach einem der vorhergehenden zwei Ansprüche, umfassend mindestens einen der folgenden Schritte:

- es wird ein Gasgemisch verwendet, das Stickstoff oder eine Stickstoff haltige Verbindung enthält;
- die Stickstoff-Menge wird durch einen Restgasanteil bestimmt, wobei Stickstoff als Verunreinigung der Ausgangsverbindungen vorliegt;
- Stickstoff wird in einem Vakuumprozess, mittels eines Restgasanteils, über eine Leckrate dosiert;
- es wird eine Leckrate verwendet, deren Höhe in einem Bereich von $1,5 \times 10^{-4}$ - $9 \times 10^{-1}$ mbar l/s ist;
- Stickstoff wird in alle Schichten (4a, 4b) der Schutzschicht (4) eingefügt;
- es wird eine SiC oder SiC:OH Schutzschicht (4) unter Zersetzung eines Precursors abgeschieden;
- als Precursor wird ein Gas mit einer Si-Si Bindung, vorzugsweise ein Disilan, besonders bevozugt ein Hexamethyldisilan verwendet;
- es werden Pulse mit variabler Pulsdauer und/oder variablen Pulspausen verwendet;
- es wird eine Prozesstemperatur in einem Bereich von 25°C - 400°C oder in einen Bereich von 30°C - 300°C verwendet.

12. Verfahren nach einem der vorhergehenden drei Ansprüche, umfassend mindestens einen der folgenden Schritte:

- der Substrat-Kontaktbereich (6) wird während des Herstellprozesses des Substrats (2) erzeugt, vorzugsweise bei einer Substrattemperatur >= 130°C, bevorzugt bei einer Substrattemperatur >= 300°C, besonders bevorzugt bei einer Substrattemperatur >= 500°C;
- der Substrat-Kontaktbereich (6) wird ohne Einwirkung eines Plasmas erzeugt;
- der Substrat-Kontaktbereich (6) wird vor der Aufbringung der Schutzschicht (4) gewaschen und vorzugsweise getrocknet, wobei vorzugsweise nach dem Waschen und Trocknen die unterschiedliche Beschaffenheit des Substrat-Kontaktbereich (6) erhalten bleibt;
- das Trocknen erfolgt bei einer Temperatur > 200°C;
- die Schutzschicht (4) wird mittels eines gepulsten Plasmas mit einer Pulsdauer >= 0,25ms, vorzugsweise >=1ms erzeugt;
- das Erzeugen der Schutzschicht (4) wird mittels inline-Messen einer Lichtabsorption in einem Wellenlängenbereich < 480nm kontrolliert oder gesteuert.

13. Behälter für ein medizinisches oder pharmazeutisches Produkt, der aus einem Verbundmaterial (1) nach einem der Ansprüche 1 bis 8 besteht.

14. Verwendung eines Verbundmaterials (1) nach einem der Ansprüche 1 bis 8 in einem Hohlkörper, der als

- ein Rohr, oder
- ein Behälter, oder
- ein pharmazeutischen Packmittel, oder
- ein Fläschchen, oder
- eine Spritze, oder
- eine Karpule, oder
- eine Ampulle

für ein flüssiges Produkt ausgebildet ist, zur Verhinderung einer Glas-Delamination in Bereichen der Innenoberfläche des Hohlkörpers unter Wechselwirkung mit einer flüssigen Lösung, beispielsweise einer wässrigen Lösung, oder einer Pufferlösung für medizinische Anwendungen.

15. Verwendung nach dem vorhergehenden Anspruche, wobei der Hohlkörper in einem Prozess, umfassend mindestens einen der folgenden Schritte, verwendet wird:

- der Behälter wird vor der Abfüllung gewaschen;
- der Behälter wird mit einer wässrigen Lösung gewaschen, die Reinigungsmittel oder Detergenzien umfasst;
- der Behälter wird mit einem sauren oder alkalischen Reiniger gewaschen.

**Claims**

1. A composite material for a pharmaceutical packaging, comprising a substrate (2) and a protective layer (4); wherein

- the substrate (2) includes a contact zone (6) with the protective layer (4), which contact zone comprises the contact area between the substrate (2) and the protective layer (4) and a near-surface zone of the protective layer (4);
- the substrate (2) is made of glass or of a cyclic olefin polymer or a cyclic olefin copolymer;
- the nature of the substrate (2) in the contact zone (6) is different from the nature of the substrate (2) outside the contact zone (6), said nature relating to at least one of: a surface roughness, a chemical composition, a surface energy, a chemical etching rate of the substrate (2); and
- the protective layer (4) is made of a ceramic material.

2. The composite material according to claim 1, **characterised by** at least one of the following features:

- the substrate (2) is made of glass of hydrolytic class I to V;
- the substrate (2) is made of borosilicate glass of hydrolytic class I.

3. The composite material according to any one of claims 1 or 2, **characterised by** at least one of the following features:

- the surface roughness of the substrate (2) in the contact zone (6) is different from the surface roughness of the substrate (2) outside the contact zone (6);
- the chemical composition of the substrate (2) in the contact zone (6) is different from the chemical composition of the substrate (2) outside the contact zone (6);
- the surface energy of the substrate (2) in the contact zone (6) is different from the surface energy of the substrate (2) outside the contact zone (6);
- the chemical etching rate of the substrate (2) in the contact zone (6) is different from the chemical etching rate of the substrate (2) outside the contact zone (6).

4. The composite material according to any one of the preceding claims, **characterised by** at least one of the following features:

- the protective layer (4) is bonded to the surface of the substrate (2) by van der Waals forces and/or covalently;
- the protective layer (4) is amorphous, in particular partially crystalline or crystalline, preferably deposited from the vapour phase;
- the protective layer (4) is free of silicon dioxide ($SiO_2$), at least in a portion thereof.

5. The composite material according to any one of the preceding claims, **characterised in that** the protective layer (4) includes one or more of the following substances or bonds:

- silicon carbide SiC;
- hydrogenated oxidized silicon carbide SiC:OH;
- nitrided oxidized hydrogenated silicon carbide SiC:OHN;
- nitrogen;
- N-H bonds, or C-N bonds.

6. The composite material according to any one of the preceding claims, **characterised by** at least one of the following features:

- the protective layer (4) comprises two sub-layers (4a, 4b), a first layer (4a) formed as a base layer and a second layer (4b) formed as a near-surface layer;
- the second layer (4b) has a composition different from that of the first layer (4a);
- the second layer (4b) has a content of nitrogen and/or oxygen and/or carbon different from that of the first layer (4a);
- the content of nitrogen and/or oxygen and/or carbon in the second layer (4b) is gradually changing as a function of a local distance from the first layer (4a), starting with the content of the first layer (4a).

7. The composite material according to any one of the preceding claims, **characterized by** at least one of the following features:

- a ratio alpha, preferably determined by X-ray photoelectron spectrometry (XPS), of the carbon content to the silicon content in the protective layer has a value in a range of 0.8 < alpha < 7, or 2.5 < alpha < 5, or 3.1 < alpha < 5;
- a ratio beta, preferably determined by X-ray photoelectron spectrometry (XPS), of the nitrogen content to the silicon content in the protective layer has a value in a range of 0 < beta < 3, or 0 < beta < 0.5, or 0 < beta < 0.1;
- the carbon content c1(C) in the first sub-layer (4a) has a value $c1(C) \geq 40$ %, or $c1(C) \geq 45$ %, or $c1(C) \geq 50$ %;
- the nitrogen content c2(N) in the second layer (4b) has a value $c2(N) \geq 0.1$ %;
- the nitrogen content c1(N) in the first layer (4a) has a value $c1(N) \geq 0.01$ %, or $c1(N) \geq 0.05$ %;
- the oxygen content c2(O) in the second sub-layer (4b) has a value $c2(O) \geq 5$ %, or $c2(O) \geq 10$ %, or $c2(O) \geq 15$ %;
- the second sub-layer (4b) has a nitrogen density, oxygen density, and/or carbon density of > 1.7 $g/cm^3$, or > 1.65 $g/cm^3$.

8. The composite material according to any one of the preceding claims for a pharmaceutical packaging, comprising a substrate (2) and a protective layer (4), wherein

- the substrate (2) includes a contact zone (6) with the protective layer (4), which contact zone comprises the contact area between the substrate (2) and the protective layer (4) and a near-surface zone of the protective layer (4);
- the substrate (2) is made of a cyclic olefin polymer or a cyclic olefin copolymer;
- the nature of the substrate (2) in the contact zone (6) is different from the nature of the substrate (2) outside the contact zone (6), said nature relating to at least one of: a surface roughness, a chemical composition, a surface energy, a chemical etching rate of the substrate (2); and wherein

- the protective layer (4) is made of a ceramic material and includes one or more of the following substances or bonds:
  - silicon carbide SiC;
  - hydrogenated oxidized silicon carbide SiC:OH;
  - nitrided oxidized hydrogenated silicon carbide SiC:OHN;
  - nitrogen;
  - N-H bonds, or C-N bonds.

9. A method for producing a composite material (1) that comprises a substrate (2) and a protective layer (4),

   - wherein the substrate (2) includes a contact zone (6) with the protective layer (4), which contact zone comprises the contact area between the substrate (2) and the protective layer (4) and a near-surface zone of the protective layer (4);
   - wherein the substrate (2) is made of glass and the nature of the substrate (2) in a near-surface zone of the substrate (2) is different from the nature of the substrate (2) outside the near-surface zone, said nature relating to at least one of: a surface roughness, a chemical composition, a surface energy, a chemical etching rate of the substrate (2); and
   - wherein the protective layer (4) made of a ceramic material is deposited onto the substrate (2) using a plasma.

10. The method according to the preceding claim, comprising at least one of the following steps:

    - the protective layer (4) is deposited on the substrate (2) using a pulsed microwave CVD plasma;
    - the substrate (2) is preheated prior to the deposition of the protective layer (4), preferably using a plasma process;
    - a plasma surface treatment of the glass surface is performed prior to the deposition of the protective layer (4);
    - after the deposition of the protective layer (4), the coated substrate (2) is thermally post-treated at a temperature of T > 240 °C, preferably for a duration of t > 3 min;
    - after the deposition of the protective layer (4), the coated substrate (2) is oxidized by first shutting down the plasma by interrupting the power supply and then supplying an oxygen-containing gas for subsequent oxidation.

11. The method according to any one of the two preceding claims, comprising at least one of the following steps:

    - a gas mixture is used, which includes nitrogen or a nitrogen-containing compound;
    - the amount of nitrogen is defined by a content of residual gas, wherein nitrogen is present as an impurity of the starting compounds;
    - nitrogen is metered in a vacuum process by a leakage rate, through a content of residual gas;
    - a leakage rate is used which ranges from $1.5*10^{-4}$ to $9*10^{-1}$ mbar·l/s;
    - nitrogen is introduced into all layers (4a, 4b) of the protective layer (4);
    - a SiC or SiC:OH protective layer (4) is deposited under decomposition of a precursor;
    - a gas with a Si-Si bond is used as a precursor, preferably a disilane, more preferably a hexamethyldisilane;
    - pulses of variable pulse duration and/or with variable pulse intervals are used;
    - a process temperature is used in a range from 25 °C to 400 °C, or in a range from 30 °C to 300 °C.

12. The method according to any one of the three preceding claims, comprising at least one of the following steps:

    - the substrate contact zone (6) is created during the manufacturing process of the substrate (2), preferably at a substrate temperature of $\geq$ 130 °C, more preferably at a substrate temperature of $\geq$ 300 °C, most preferably at a substrate temperature of $\geq$ 500 °C;
    - the substrate contact zone (6) is created without action of a plasma;
    - prior to the deposition of the protective layer (4), the substrate contact zone (6) is washed and preferably dried, wherein, preferably, the different nature of the substrate contact zone (6) is retained after the washing and drying;
    - the drying is performed at a temperature of > 200 °C;
    - the protective layer (4) is generated using a pulsed plasma with a pulse duration of $\geq$ 0.25 ms, preferably $\geq$ 1 ms;
    - the generation of the protective layer (4) is monitored or controlled by inline measurement of a light absorption in a wavelength range of < 480 nm.

**13.** A container for a medical or pharmaceutical product, consisting of a composite material (1) according to any one of claims 1 to 8.

**14.** Use of a composite material (1) according to any one of claims 1 to 8 in a hollow body which is in the form of

- a tube, or
- a container, or
- a pharmaceutical packaging, or
- a vial, or
- a syringe, or
- a carpule, or
- an ampoule

for a liquid product, for preventing delamination of glass in areas of the inner surface of the hollow body under interaction with a liquid solution, for example an aqueous solution, or a buffering solution for medical applications.

**15.** Use according to the preceding claim, wherein the hollow body is used in a process comprising at least one of the following steps:

- the container is washed prior to being filled;
- the container is washed with an aqueous solution comprising cleaning agents or detergents;
- the container is washed with an acidic or alkaline cleaning agent.

**Revendications**

**1.** Matériau composite destiné à un emballage pharmaceutique, comprenant un substrat (2) et une couche de protection (4), dans lequel

- le substrat (2) présente une zone de contact (6) avec la couche de protection (4), qui comprend la surface de contact entre le substrat (2) et la couche de protection (4), ainsi qu'une zone, proche de la surface, de la couche de protection (4),
- le substrat (2) est réalisé à partir de verre ou d'un polymère de cyclooléfine ou d'un copolymère de cyclooléfine,
- la nature du substrat (2) dans la zone de contact (6) est différente de la nature du substrat (2) à l'extérieur de la zone de contact (6), la nature concernant au moins l'un des aspects suivants : une rugosité de surface, une composition chimique, une énergie superficielle, un taux de corrosion chimique du substrat (2), et
- la couche de protection (4) est constituée d'un matériau céramique.

**2.** Matériau composite selon la revendication 1, **caractérisé en ce qu'**il présente au moins une des propriétés suivantes :

- le substrat (2) est réalisé à partir de verre de la classe hydrolytique I-V ;
- le substrat (2) est réalisé à partir de verre borosilicaté de la classe hydrolytique I.

**3.** Matériau composite selon l'une des revendications 1 ou 2, **caractérisé en ce qu'**il présente au moins une des propriétés suivantes :

- la rugosité de surface du substrat (2) dans la zone de contact (6) est différente de la rugosité de surface du substrat (2) à l'extérieur de la zone de contact (6) ;
- la composition chimique du substrat (2) dans la zone de contact (6) est différente de la composition chimique du substrat (2) à l'extérieur de la zone de contact (6) ;
- l'énergie superficielle du substrat (2) dans la zone de contact (6) est différente de l'énergie superficielle du substrat (2) à l'extérieur de la zone de contact (6) ;
- le taux de corrosion chimique du substrat (2) dans la zone de contact (6) est différent du taux de corrosion chimique du substrat (2) à l'extérieur de la zone de contact (6).

**4.** Matériau composite selon l'une des revendications précédentes, **caractérisé en ce qu'**il présente au moins une des propriétés suivantes :

- la couche de protection (4) est liée à la surface du substrat (2) par des forces de van der Waals et/ou par une liaison covalente ;
- la couche de protection (4) est déposée sous une forme amorphe, notamment de façon partiellement cristalline ou cristalline, de préférence à partir de la phase gazeuse ;
- la couche de protection (4) est dépourvue de dioxyde de silicium ($SiO_2$), au moins dans une zone partielle.

5. Matériau composite selon l'une des revendications précédente, **caractérisé en ce que** la couche de protection (4) contient une ou plusieurs des substances ou un ou plusieurs des composés ci-après :

- carbure de silicium SiC ;
- carbure de silicium oxydé hydrogéné SiC:OH ;
- carbure de silicium hydrogéné oxydé nitruré SiC:OHN ;
- azote ;
- liaisons N-H ou liaisons C-N.

6. Matériau composite selon l'une des revendications précédente, **caractérisé en ce qu'**il présente au moins une des propriétés suivantes :

- la couche de protection (4) comporte deux couches partielles (4a, 4b), une première couche étant réalisée en tant que couche de base, et une deuxième couche (4b) étant réalisée en tant que couche proche de la surface ;
- la deuxième couche (4b) présente une composition différente par rapport à la première couche (4a) ;
- la deuxième couche (4b) présente une teneur en azote et/ou en oxygène et/ou en carbone différente par rapport à la première couche (4a) ;
- dans la deuxième couche (4b), la teneur en azote et/ou en oxygène et/ou en carbone varie en continu en partant de la teneur de la première couche (4a), en fonction d'une distance locale par rapport à la première couche (4a).

7. Matériau composite selon l'une des revendications précédentes, **caractérisé en ce qu'**il présente au moins une des propriétés suivantes :

- le rapport alpha = part de carbone à part de silicium dans la couche de protection, déterminé de préférence par spectrométrie photoélectronique par rayons X (XPS), présente une valeur comprise dans la plage 0,8 < alpha < 7, ou 2,5 < alpha < 5, ou 3,1 < alpha < 5 ;
- le rapport bêta = part d'azote à part de silicium dans la couche de protection, déterminé de préférence par spectrométrie photoélectronique par rayons X (XPS), présente une valeur comprise dans la plage 0 < bêta < 3, ou 0 < bêta < 0,5, ou 0 < bêta < 0,1 ;
- la part de carbone c1(C) dans la première couche partielle (4a) présente une valeur c1(C) >= 40 %, ou c1(C) >= 45 %, ou c1(C) >= 50 % ;
- la part d'azote c2(N) dans la deuxième couche (4b) présente une valeur c2(N) >= 0,1 % ;
- la part d'azote c1(N) dans la première couche (4a) présente une valeur c1(N) >= 0,01 %, ou c1(N) >= 0,05 % ;
- la part d'oxygène c2(O) dans la deuxième couche partielle (4b) présente une valeur c2(O) >= 5 %, ou c2(O) >= 10 % ou c2(O) >= 15 % ;
- la deuxième couche partielle (4b) présente une densité d'azote, une densité d'oxygène et/ou une densité de carbone > 1,7 g/cm3, ou > 1,65 g/cm3.

8. Matériau composite selon l'une des revendications précédentes, destiné à un emballage pharmaceutique, comprenant un substrat (2) et une couche de protection (4), dans lequel

- le substrat (2) présente une zone de contact (6) avec la couche de protection (4), qui comprend la surface de contact entre le substrat (2) et la couche de protection (4), ainsi qu'une zone, proche de la surface, de la couche de protection (4),
- le substrat (2) est réalisé à partir d'un polymère de cyclooléfine ou d'un copolymère de cyclooléfine,
- la nature du substrat (2) dans la zone de contact (6) est différente de la nature du substrat (2) à l'extérieur de la zone de contact (6), la nature concernant au moins l'un des aspects suivants : une rugosité de surface, une composition chimique, une énergie superficielle, un taux de corrosion chimique du substrat (2), et dans lequel
- la couche de protection (4) est constituée d'un matériau céramique et contient une ou plusieurs des substances ou un ou plusieurs des composés ci-après :

- carbure de silicium SiC ;
- carbure de silicium oxydé hydrogéné SiC:OH ;
- carbure de silicium hydrogéné oxydé nitruré SiC:OHN ;
- azote ;
- liaisons N-H ou liaisons C-N.

**9.** Procédé de fabrication d'un matériau composite (1) comprenant un substrat (2) et une couche de protection (4),

- selon lequel le substrat (2) présente une zone de contact (6) avec la couche de protection (4), qui comprend la surface de contact entre le substrat (2) et la couche de protection (4), ainsi qu'une zone, proche de la surface, de la couche de protection (4),
- selon lequel le substrat (2) est réalisé en verre, et la nature du substrat (2), dans une zone du substrat (2) proche de la surface, est différente de la nature du substrat (2) à l'extérieur de la zone proche de la surface, et la nature concernant au moins l'un des aspects suivants : une rugosité de surface, une composition chimique, une énergie superficielle, un taux de corrosion chimique du substrat (2), et
- selon lequel la couche de protection (4) constituée d'un matériau céramique est déposée sur le substrat (2) au moyen d'un plasma.

**10.** Procédé selon la revendication précédente, comprenant au moins une des étapes suivantes :

- la couche de protection (4) est déposée sur le substrat (2) par CVD assisté par plasma micro-onde puisé ;
- avant le dépôt de la couche de protection (4), le substrat (2) est préchauffé, de préférence au moyen d'un procédé au plasma ;
- avant le dépôt de la couche de protection (4), on réalise un traitement de surface au plasma de la surface du verre ;
- après le dépôt de la couche de protection (4), le substrat (2) revêtu est soumis à un traitement thermique ultérieur, à une température T > 240 °C, de préférence pendant une durée t > 3 min ;
- après le dépôt de la couche de protection (4), le substrat (2) revêtu est oxydé, opération lors de laquelle le plasma est d'abord coupé par interruption de l'alimentation en énergie, et ensuite on apporte un gaz contenant de l'oxygène, en vue de l'oxydation ultérieure.

**11.** Procédé selon l'une des revendications précédentes, comprenant au moins une des étapes suivantes :

- on utilise un mélange gazeux qui contient de l'azote ou un composé contenant de l'azote ;
- la quantité d'azote est définie par une part de gaz résiduel, où l'azote est présent en tant qu'impureté des composés de départ ;
- l'azote est dosé par le biais d'un taux de fuite au cours d'un procédé sous vide, à l'aide d'une part de gaz résiduel ;
- on utilise un taux de fuite dont la valeur se situe dans une plage allant de 1,5x10-4 à 9x10-1 mbars l/s ;
- l'azote est introduit dans toutes les couches (4a, 4b) de la couche de protection (4) ;
- une couche de protection (4) de SiC ou Sic:OH est déposée par décomposition d'un précurseur ;
- en tant que précurseur, on utilise un verre avec une liaison Si-Si, de préférence un disilane, et de manière particulièrement avantageuse un hexaméthyl-disilane ;
- on utilise des impulsions à durée d'impulsion variable et/ou à intervalles entre impulsions variables ;
- on utilise une température de procédé comprise dans une plage allant de 25 °C à 400 °C ou dans une plage allant de 30 °C à 300 °C.

**12.** Procédé selon l'une des trois revendications précédentes, comprenant au moins une des étapes suivantes :

- la zone de contact (6) du substrat est réalisée pendant le processus de fabrication du substrat (2), de préférence à une température de substrat >= 130 °C, de préférence à une température de substrat >= 300 °C, et de manière particulièrement avantageuse à une température de substrat >= 500 °C ;
- la zone de contact (6) du substrat est réalisée sans l'action d'un plasma ;
- avant l'application de la couche de protection (4), la zone de contact (6) du substrat est lavée et de préférence séchée, sachant que les différences dans la nature de la zone de contact (6) du substrat sont de préférence conservées après le lavage et le séchage ;
- le séchage est effectué à une température > 200 ;
- la couche de protection (4) est réalisée à l'aide d'un plasma pulsé, avec une durée d'impulsion >= 0,25 ms, de préférence >= 1 ms ;

- la réalisation de la couche de protection (4) est contrôlée ou commandée par mesure de type inline d'une absorption de lumière dans une gamme de longueurs d'ondes < 480 nm.

13. Récipient pour un produit médical ou pharmaceutique, qui est constitué d'un matériau composite (1) selon l'une des revendications 1 à 8.

14. Utilisation d'un matériau composite (1) selon l'une des revendications 1 à 8, dans un corps creux qui est réalisé en tant que

- tube, ou
- récipient, ou
- emballage pharmaceutique, ou
- petit flacon, ou
- seringue, ou
- carpule, ou
- ampoule

pour un produit liquide, afin d'empêcher une délamination du verre dans des zones de la surface interne du corps creux, lors de l'interaction avec une solution liquide, par exemple une solution aqueuse, ou une solution tampon destinée à des applications médicales.

15. Utilisation selon la revendication précédente, où le corps creux est utilisé lors d'un processus comprenant au moins l'une des étapes suivantes :

- le récipient est lavé avant le remplissage ;
- le récipient est lavé avec une solution aqueuse qui comprend des produits de nettoyage ou des détergents ;
- le récipient est lavé avec un nettoyant acide ou alcalin.

Fig. 1

Fig. 2

Fig. 3

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0858975 A1